# EUROPEAN PATENT SPECIFICATION

(11) **EP 2 020 090 B1**
(45) Date of publication and mention of the grant of the patent: **25.02.2015**
(21) Application number: 07730761.9
(22) Date of filing: 15.05.2007
(51) Int. Cl.: H04W 52/24, H04W 52/52, H04B 1/38, H03G 3/00, H04B 1/04, H04B 17/00, H04B 7/26

(54) **ANTENNA MATCHING MEASUREMENT AND AMPLIFICATION CONTROL**
ANTENNENANPASSUNGSMESSUNG UND VERSTÄRKUNGSREGELUNG
MESURE D'ADAPTATION D'ANTENNE ET COMMANDE D'AMPLIFICATION

(30) Priority: 18.05.2006 FI 20065339; 25.07.2006 US 491948
(43) Date of publication of application: 04.02.2009
(73) Proprietor: Nokia Corporation, 02610 Espoo (FI)
(72) Inventor: HEINONEN, Jarmo J., 24280 Salo (FI); VILHONEN, Sami, 21420 Lieto (FI); VIGELIUS, Kari, 24240 Salo (FI); PETTERSSON, Markus, 20780 Kaarina (FI); VIITANIEMI, Vesa, 25460 Kisko (FI)
(74) Representative: Kolster Oy Ab
(86) International application number: PCT/FI2007/050274
(87) International publication number: WO 2007/135235

(56) References cited:
- WO-A1-2004/098076
- FI-B- 109 059
- GB-A- 2 323 987
- US-A- 5 521 904
- US-A- 5 790 944
- US-A- 5 819 165
- US-A1- 2004 061 554
- US-A1- 2005 200 407
- US-B1- 6 741 640

## Description

### Field

The invention relates to an antenna matching measurement and to amplification control of a transceiver in a radio system.

### Background

The total radiated power targets of the mobile phones are getting tighter. The transmitter ought to follow the requirements and to be able to transmit using a proper power in any situation. If the antenna matching is at the optimum, for example 50 ohm, the transmitter can usually transmit with a sufficiently accurate power. The transmitter may also have an output sensor whose measurement can be calibrated with an external measurement during feeding a known output power to the known load to increase the accuracy of the radiated transmission power.

However, the antenna matching can vary to a certain extent, causing mismatch for the transmitter chain inside the mobile phone, which results in an undesired total radiated power. For example, the antenna impedance is not exactly the matched 50 ohm over the whole transmission frequency band used. Also the antenna matching may change as a function of conditions. The antenna matching can be different depending on whether, for example, the phone is kept in hand or near any surface. The surface's conductivity may also have some effect. The patent document GB 2323987 presents a radio transceiver amplifier with closed loop gain control feedback for a trunked mode and open loop bias feedback for direct mode. The patent document WO 2004098076 presents a system and a method for adaptive antenna impedance matching. The patent document US 6741640 presents a system and a method for measuring the return loss of an antenna.

To fulfill the power requirements at any loading impedance, the transmission power of the transceiver has been tuned in prior art solutions high enough such that the variation caused by antenna matching is tolerated.

Although it is important that the mobile phone works well in any situation, the prior art solutions lead to a poor performance and a high operational power consumption from the battery to compensate for the matching losses.

### Brief description of the invention

An object of the invention is to provide improved methods, transceiver, mobile phone and computer programs of antenna matching measurement and amplification control. According to an aspect of the invention, there is provided a method according to claim 1.

According to another aspect of the invention, there is provided a transceiver according to claim 6.

According to another aspect of the invention, there is provided a computer program configured to execute a computer process according to claim 11.

The invention provides several advantages. The radiated transmission power from the antenna can be kept within required limits and a proper radiated transmission power can be used in all conditions. Current consumption can also be lowered.

### List of drawings

In the following, the invention will be described in greater detail with reference to the embodiments and the accompanying drawings, in which
Figure 1 shows a radio system;
Figure 2A illustrates a transceiver with a parallel measurement branch to the receiver;
Figure 2B illustrates a transceiver utilizing the receiver for the signal strength measurement;
Figure 3 illustrates a burst and an amplitude envelope;
Figure 4 illustrates a flow chart of the method of controlling amplification; and
Figure 5 illustrates a flow chart of the method of measuring antenna matching.

### Description of embodiments

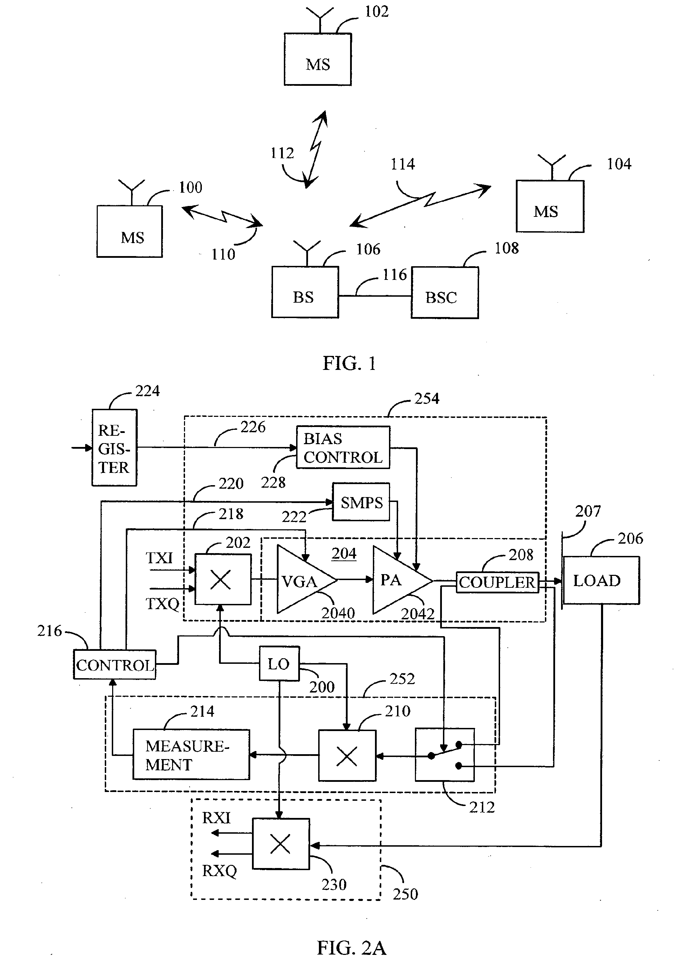

First, a radio system, such as the GSM (Global System for Mobile communication), the (W)CDMA ((Wide-band) Code Division Multiple Access) or the UMTS (Universal Mobile Telecommunications Service), is described by means of Figure 1. A typical digital radio system comprises subscriber equipment 100 to 104, at least one base station 106, and a base station controller 108. The base station 106 can also be called a node-B and the base station controller 108 can also be called a radio network controller depending on the radio system. The subscriber equipment 100 to 104 communicates with the base station 106 using signals 110 to 114. The base station 106 can be connected to the base station controller 108 by a digital transmission link 116. The subscriber equipment 100 to 104 may be fixedly installed terminals, user equipment installed in a vehicle or portable mobile terminals. The signals 110 to 114 between the subscriber equipment 100 to 104 and the base station 106 carry digitized information, which is e.g. speech or data information produced by subscribers or control information produced by the radio system.

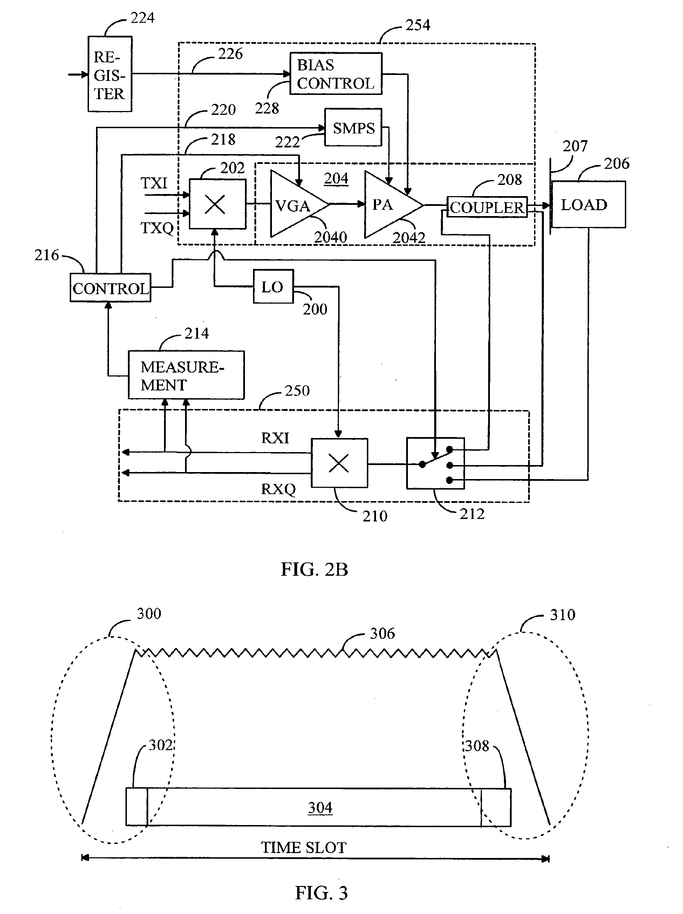

With reference to Figure 2A, examine now an example of a transceiver, such as the one in a base station or in user equipment. Figure 2A illustrates a solution where the feedback from the antenna to the control of the amplifier is realized utilizing a measurement branch 252 parallel to the receiver 250 of the transceiver. A signal to be transmitted is fed from baseband parts in a quadrature format to a multiplier 202, where the real signal part I (Inphase) and the imaginary signal part Q (Quadrature) are multiplied by a carrier coming from a local oscillator 200. The real signal part I can be multiplied by a carrier without phase shift and the imaginary signal part Q (Quadrature) can be multiplied by a phase shifted carrier. The phase shift is 90°. Thus, the signal s to be transmitted can be expressed as s = I + jQ, where j is an imaginary unit. The multiplier 202 may also combine the signal parts and feed the combined signal to an amplifier unit 204, which receives a control signal controlling at least one parameter of the amplifier unit 204. The amplifier unit 204 passes the signal to be transmitted towards an antenna 206. A coupler 208 may be coupled between the amplifier unit 204 and the antenna 206. The coupler 208 samples a part of a radio frequency signal traveling between the amplifier unit 204 and the antenna 206 for a converter 210. The converter 210 down converts the sampled radio frequency signal by multiplying the sampled signal by the carrier coming from the local oscillator 200 and band pass filtering. The converter 210, may output a digital base band signal in a quadrature form. After the converter 210 the signal may be amplified and filtered, but these operations have not been shown in Figures 2A and 2B.

The coupler 208 may be a directional coupler used to couple either a part of a signal traveling in the direction from the amplifier unit 204 towards the antenna 206 or a part of a signal reflected from the antenna 206 or from a connector of the antenna 206 traveling in the direction from the antenna 206 towards the amplifier unit 204. Naturally, the coupler 208 may also be used to couple both of these samples to the converter 210. The coupler 208 may have coupling of about 20dBs or directivity of about 20dBs, for example.

If the coupler 208 is capable of delivering more than one sample to the converter 210, a switch 212 may be used to select the sample to be down converted. The switch 212 may be used to successively select a sample of the signal traveling in the direction from the amplifier unit 204 towards the antenna 206 or a part of a signal reflected from the antenna 206 (or antenna connector) traveling in the direction from the antenna 206 towards the amplifier unit 204.

A measuring unit 214 may receive the down converted radio frequency signal output by the converter 210 and measure a strength of the down converted radio frequency signal. The strength may be measured as a power or as an absolute amplitude. The measurement of power P of a signal in a quadrature form may be expressed in a mathematical form as P = I² + Q², and the I and the Q parts can be understood as voltages of the samples. The measuring unit 214 may be a peak detector outputting a DC signal whose level depends on the strength. The analog DC signal can be transformed to a digital format by an analog-to-digital converter.

A controller 216 may receive the measured strength of the sampled radio frequency signal. The controller 216 may form at least one control signal 218, 220 whose control information depends on the measured strength in order to control at least one parameter of the amplifier unit 204.

The amplifier unit 204 may include a variable gain amplifier 2040 which amplifies the signal to be transmitted. The signal may be, for example, a burst used in the GSM or in the (W)CDMA radio system. The amplification of the variable gain amplifier 2040 may be a parameter to be controlled. Hence, the amplification of the variable gain amplifier 2040 may be varied according to the control signal 218 such that the amplification is adjusted as a function of the measured strength in the measuring unit 214.

The amplifier unit 204 may include a power amplifier 2042 which amplifies the signal to be transmitted. The power supply to the power amplifier 2042 may be a parameter to be controlled and hence the power amplifier 2042 may obtain its operational voltage from a power supply unit 222, which may be controllable. The power supply unit 222 may receive a control signal 220 from the controller 216. For example, the power supply unit 222 may be a switched-mode power supply of open loop type whose output voltage depends on the pulse width of a control signal 220. The output voltage of the power supply unit 222 may be tabulated according to the accepted power levels and bands of the radio system. The controller 216 may also receive a piece of information on the voltage of the battery of the transceiver and calculate a correct pulse width for the power supply unit 222 to output a voltage suitable for the power amplifier 2042. Information on the correct pulse width may be delivered to the power supply unit 222 in digital form using an RF bus.

Also a bias current of the power amplifier 202 may be a parameter to be controlled, and different bands and modes can be differently biased. A register 224 may receive information on the amplitude or the power of the signal to be transmitted. Based on the received information, the register 224 may form a bias control signal 226 to be fed to a bias controller 228 which sets a suitable bias current to the power amplifier 2042 as a function of the bias control signal. The information on the amplitude or the power of the signal to be transmitted may be received from the controller 216. Hence, the power capability of the transmitter 254 can be increased by optimizing, for example, the power supply voltage or bias current.

In Figure 2A, the signal received by the antenna 206 is fed to the receiver 250 of the transceiver which has a down converter 230 of its own down which may form a base band signal having a quadrature format.

The measurement branch 252 parallel to the receiver 250 of the transceiver may be active only from time to time. The active periods may recur regularly or irregularly. For instance, when the phone is in normal use, the parallel receiver can be used to control the high output power levels, since a high absolute accuracy of reporting power or sending output power is only required at high power levels in WCDMA - in lower levels the relative accuracy is enough. In this way, the parallel receiver needs only narrow dynamic range and is easier and smaller to realize. This decreases the consumption of electricity and enables longer use of battery without recharging.

Figure 2B is in many parts similar to Figure 2A. Figure 2B illustrates a solution where the feedback from the antenna to the control of the amplifiers is realized utilizing the receiver 250 of the transceiver. When the output of the coupler 208 and the signal received by the antenna 206 are coupled to a down converter 210, the switch 212 may be used to select the signal to be down converted. The converter 210 may output a digital signal in a base band. The switch 212 may be used to successively select a sample of the signal traveling towards the antenna 206, a sample reflected from the antenna 206 (or antenna connector) or a signal received by the antenna 206. The measuring unit 214 may receive the sample and measure the strength of the sample. In the case of the signal received by the antenna in particular, the signal may proceed further into the receiver after the measurement of the strength.

For example, the transmitter's own receiver 250 can give a wide dynamic range for tuning WCDMA transmitter output power levels. This is possible after simple power reference calibration as explained in background. The self calibration saves time and money (value of measurement devices) in production and is very accurate (a plenty of time is available for proper fine tuning). In a manner similar to the one described in Figure 2A, the measurement of the signal strength in the measurement unit 214 may be active only from time to time. The active periods may recur regularly or irregularly.

Using the receiver 250 of the transceiver for power measurement gives the possibility of having a high isolation against power devices, such as the amplifier unit, the antenna, etc., and against low level/high sensitive devices, like the transmitter I/Q-modulator and the local oscillator. The high transmission power does not create remarkable harmonics or distortion products, either, as it would be if, for example, a diode detector were used together with directional coupler.

In Figures 2A and 2B the switches may be controlled by the controller 216 to guide signals properly.

Assume now that both the power of a signal traveling toward the antenna (forward power) and the power of a signal traveling in the opposite direction (reflected power) are utilized. For example, the forward power can first be measured. The desired transmission power which should be measured at least in the case of perfect matching is known. By comparing the measured result with the desired power, it is possible to check whether the transceiver is working. Then, the reflected power may be measured. By comparing the reflected power and the forward power, the real transmission power from the antenna can be known.

Then, a parameter controlling the power amplifier or the variable gain amplifier can be changed, if necessary, such that the power delivered to the antenna remains in or moves to a reasonable level despite poor matching (varying conditions). Naturally, parameters controlling both the power amplifier and the variable gain amplifier can be controlled and changed at the same time.

Figure 3 illustrates an amplitude envelope and bit sequences of a GSM burst although the present solution applies to bursts of other radio systems, too. At the beginning of a time slot the starting section 300 of a signal is ramped up such that a predetermined transmission power level is achieved. The transmission of the signal starts with a sequence 302 of tail bits the number of which is three. The transmission of the signal may continue with at least one sequence of data bits and at least one training sequence, or with some other sequence(s) 304. The sequences are transmitted using a predetermined power 306 within certain power limits. The transmission of the signal ends with a sequence 308 of tail bits the number of which is three and the end section 310 of the power of the signal is ramped down in order to shut down the transmission.

In an embodiment, a known signal may be sampled, down converted and measured at least partly. The part of the known signal may be, for example, tail bits of a burst in the GSM radio system. The signal transmitted by the transmitter may have a continuous sine wave offset (for example, known to be about 67 kHz with Gaussian-filtered Minimum Shift Keying (GMSK) modulation) during the ramping up and down the power of the signal and also during the tail bits in every burst. Hence, for example, in the GSM radio system in GMSK mode the baseband signal is about 67 kHz during ramp-up and again during tail bits. One signal period is then about 15 µs.

Alternatively, a signal known or not known may be a whole burst in the GSM or in the (W)CDMA radio system.

A signal to be transmitted may be sampled, down converted and measured repeatedly. The period of the repetition may be regular, variable or adaptive. Then, the at least one parameter of the amplifier unit may be set at the end of a period for the next period. The duration of the period may be, for instance, from tens of microseconds to tens of seconds.

The repetition periods may be synchronized with the transmitted bursts. Hence, it is not necessary to utilize all bursts but instead every N^{th} burst may be sampled, down converted and measured where the number N is a positive integer larger than 1. For a concrete embodiment, the number N may be, for example, 100. The at least one parameter to control the amplifier unit 204 may be set constant for a period corresponding to the duration of N bursts and after that the at least one parameter can be determined and set again.

Because the control of the transmission power is not so important when the power level is low, at least one parameter of the amplifier unit may be controlled only during signal strengths higher than a known threshold. The threshold may be, for example, 0 to 30dB down from the maximum power.

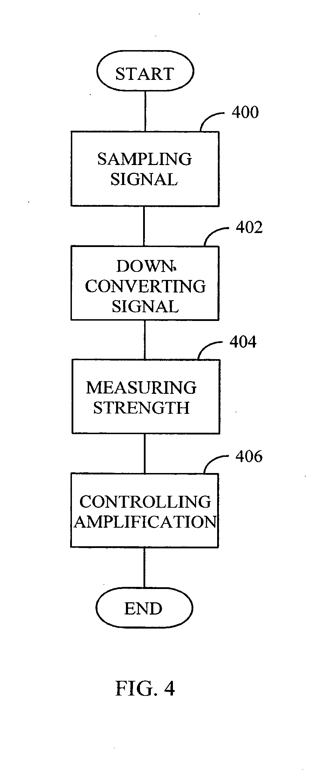

Figure 4 shows a flow chart of the method of controlling an amplifier. In step 400, a part of a radio frequency signal proceeding between an amplifier unit of a transceiver and an antenna is sampled. In step 402, the sampled radio frequency signal is down converted. In step 404, strength of the down converted signal is measured. In step 406, at least one parameter of an amplifier unit amplifying the radio frequency signal is controlled as a function of the measured strength.

The embodiments according to the method described in Figure 4 may be implemented as a computer program comprising instructions for executing a computer process for controlling amplification of a radio frequency signal in a radio frequency amplifier unit of a transceiver of a telecommunication system.

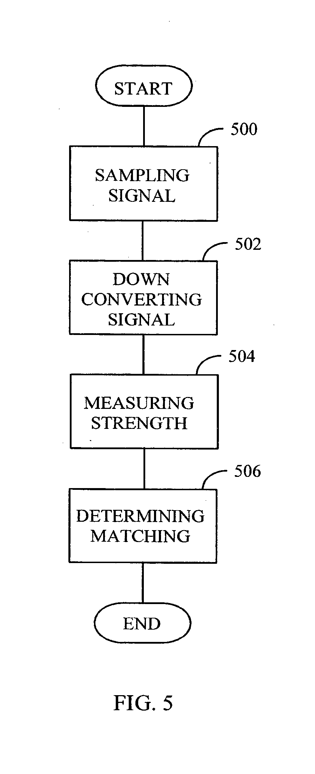

Figure 5 shows a flow chart of the method of antenna matching. In step 500, a part of a radio frequency signal proceeding between a power amplifier of a transceiver and an antenna is sampled. In step 502, the sampled radio frequency signal is down converted. In step 504, strength of the down converted signal is measured. In step 506, quality of antenna matching on the basis of the measured strength is determined. The antenna matching measurement can be used for antenna detection during production of the transceiver. If the quality of the antenna matching is good, it can be considered that the antenna is fixed properly. If, on the other hand, the quality of the antenna matching is poor, it can be considered that the antenna is not properly fixed or even missing. This solution can replace complicated test jigs and expensive measurement devices.

The embodiments according to the method described in Figure 5 may be implemented as a computer program comprising instructions for executing a computer process for measuring antenna matching.

The computer program may be stored on a computer program distribution medium readable by a computer or a processor. The computer program medium may be, for example but not limited to, an electric, magnetic, optical, infrared or semiconductor system, device or transmission medium. The computer program medium may include at least one of the following media: a computer readable medium, a program storage medium, a record medium, a computer readable memory, a random access memory, an erasable programmable read-only memory, a computer readable software distribution package, a computer readable signal, a computer readable telecommunications signal, computer readable printed matter, and a computer readable compressed software package.

Even though the invention has been described above with reference to an example according to the accompanying drawings, it is clear that the invention is not restricted thereto but it can be modified in several ways within the scope of the appended claims.

## Claims

1. A method, comprising:
selectively sampling (400), with a coupler (208), both at least a part of a radio frequency signal travelling from an amplifier unit (204) towards an antenna (206) of a transceiver for a telecommunication system and at least a part of the radio frequency signal reflected from the antenna (206) ;
down converting (402) the sampled radio frequency signals;
measuring (404) strengths of the down converted signals; and
controlling (406), as a function of the measured strengths, at least one parameter of the amplifier unit (204) amplifying the radio frequency signal.

2. The method of claim 1, the method further comprising:
selectively sampling at least a part of the radio frequency signal received by the antenna (206).

3. The method of claim 1, the method further comprising:
controlling a parameter which is an amplification of the amplifier unit (204).

4. The method of claim 1, the method further comprising:
controlling a parameter which is a power supplied to the amplifier unit (204).

5. The method of claim 1, the method further comprising:
receiving, by a switch (212), the signal traveling in the direction from the amplifier unit (204) towards the antenna 206 and a part of a signal reflected from the antenna (206) traveling in the direction from the antenna 206 towards the amplifier unit (204);
successively selecting, by the switch (212) one signal received by the switch (212) to the down conversion.

6. A transceiver for a telecommunication system, said transceiver comprising:
means (208) for selectively sampling both at least a part of a radio frequency signal traveling from a radio frequency amplifier unit (204) towards an antenna (206) of the transceiver and at least a part of the radio frequency signal reflected from the antenna (206);
means (210) for down converting the sampled radio frequency signals based on the sampled radio frequency signals,
means (214) for measuring a strength of the down converted radio frequency signals based on the down converted radio frequency signals; and
means (216) for controlling at least one parameter of the amplifier unit as a function of the measured strength based on the measured strength of the sampled radio frequency signals.

7. The transceiver of claim 6, the transceiver further comprising
a coupler (208) configured to selectively sample at least a part of the radio frequency signal received by the antenna (206).

8. The transceiver of claim 6, the transceiver further comprising
a controller (216) configured to control a parameter which is an amplification of the amplifier unit (204).

9. The transceiver of claim 6, the transceiver further comprising:
a controller (216) configured to control a parameter which is a power supplied to the amplifier unit (204).

10. The transceiver of claim 6, the transceiver further comprising:
a switch (212) configured to receive the signal traveling in the direction from the amplifier unit (204) towards the antenna 206 and a part of a signal reflected from the antenna (206) traveling in the direction from the antenna 206 towards the amplifier unit (204), the switch (212) being configured to successively select one signal received by the switch (212) to the down conversion.

11. A computer program configured to execute a computer process, the process comprising:
selectively sampling (400) both at least a part of a radio frequency signal traveling from a radio frequency amplifier unit (204) towards an antenna (206) of a transceiver for a telecommunication system and at least a part of the radio frequency signal reflected from the antenna (206);
down converting (402) the sampled radio frequency signals;
measuring (404) a strength of the down converted signals; and controlling (406), as a function of the measured strength, at least one parameter of the amplifier unit amplifying the radio frequency signal.

12. The computer program of claim 11, the process further comprising:
selectively sampling at least a part of the radio frequency signal received by the antenna (206).

13. The computer program of claim 11, the process further comprising:
controlling a parameter which is an amplification of the amplifier unit (204).

14. The computer program of claim 11, the process further comprising:
controlling a parameter which is a power supplied to the amplifier unit (204).

15. The computer program of claim 11, the process further comprising:
receiving, by a switch (212), the signal traveling in the direction from the amplifier unit (204) towards the antenna 206 and a part of a signal reflected from the antenna (206) traveling in the direction from the antenna 206 towards the amplifier unit (204);
successively selecting, by the switch (212) one signal received by the switch (212) to the down conversion.

## Patentansprüche

1. Verfahren, das Folgendes umfasst:
selektives Abtasten (400) mit einem Koppler (208) sowohl wenigstens eines Teils eines Hochfrequenzsignals, das von einer Verstärkereinheit (204) zu einer Antenne (206) eines Sender/Empfängers in einem Telekommunikationssystem läuft, als auch wenigstens eines Teils eines Hochfrequenzsignals, das von der Antenne (206) reflektiert ist;
Abwärtsumsetzen (402) der abgetasteten Hochfrequenzsignale;
Messen (404) der Stärken der abwärtsumgesetzten Signale; und
Steuern (406), als eine Funktion der gemessenen Stärken, wenigstens eines Parameters der Verstärkereinheit (204), die das Hochfrequenzsignal verstärkt.

2. Verfahren nach Anspruch 1, wobei das Verfahren ferner Folgendes umfasst:
selektives Abtasten wenigstens eines Teils des durch die Antenne (206) empfangenen Hochfrequenzsignals.

3. Verfahren nach Anspruch 1, wobei das Verfahren ferner Folgendes umfasst:
Steuern eines Parameters, der eine Verstärkung der Verstärkereinheit (204) ist.

4. Verfahren nach Anspruch 1, wobei das Verfahren ferner Folgendes umfasst:
Steuern eines Parameters, der eine Leistung ist, die der Verstärkereinheit (204) zugeführt wird.

5. Verfahren nach Anspruch 1, wobei das Verfahren ferner Folgendes umfasst:
Empfangen durch einen Schalter (212) des Signals, das in der Richtung von der Verstärkereinheit (204) zu der Antenne 206 läuft, und eines Teils eines Signals, das von der Antenne (206) reflektiert ist und das in der Richtung von der Antenne 206 zu der Verstärkereinheit (204) läuft;
sukzessives Auswählen durch den Schalter (212) eines Signals, das durch den Schalter (212) empfangen wird, für die Abwärtsumsetzung.

6. Sender/Empfänger für ein Telekommunikationssystem, wobei der Sender/Empfänger Folgendes umfasst:
Mittel (208) zum selektiven Abtasten sowohl eines Teils eines Hochfrequenzsignals, das von einer Hochfrequenzverstärkereinheit (204) zu einer Antenne (206) des Sender/Empfängers läuft, als auch wenigstens eines Teils des Hochfrequenzsignals, das von der Antenne (206) reflektiert ist;
Mittel (210) zum Abwärtsumsetzen der abgetasteten Hochfrequenzsignale basierend auf den abgetasteten Hochfrequenzsignalen;
Mittel (214) zum Messen einer Stärke der abwärtsumgesetzten Hochfrequenzsignale basierend auf den abwärtsumgesetzten Hochfrequenzsignalen; und
Mittel (216) zum Steuern wenigstens eines Parameters der Verstärkereinheit als eine Funktion der gemessenen Stärke basierend auf der gemessenen Stärke der abgetasteten Hochfrequenzsignale.

7. Sender/Empfänger nach Anspruch 6, wobei der Sender/Empfänger ferner Folgendes umfasst:
einen Koppler (208), der konfiguriert ist, selektiv wenigstens einen Teil des durch die Antenne (206) empfangenen Hochfrequenzsignals abzutasten.

8. Sender/Empfänger nach Anspruch 6, wobei der Sender/Empfänger ferner Folgendes umfasst:
eine Steuereinheit (216), die konfiguriert ist, einen Parameter zu steuern, der eine Verstärkung der Verstärkereinheit (204) ist.

9. Sender/Empfänger nach Anspruch 6, wobei der Sender/Empfänger ferner Folgendes umfasst:
eine Steuereinheit (216), die konfiguriert ist, einen Parameter zu steuern, der eine Leistung ist, die der Verstärkereinheit (204) zugeführt wird.

10. Sender/Empfänger nach Anspruch 6, wobei der Sender/Empfänger ferner Folgendes umfasst:
einen Schalter (212), der konfiguriert ist, das Signal, das in der Richtung von der Verstärkereinheit (204) zu der Antenne 206 läuft und einen Teil eines Signals, das von der Antenne (206) reflektiert ist und in der Richtung von der Antenne 206 zu der Verstärkereinheit (204) läuft, zu empfangen, wobei der Schalter (212) konfiguriert ist, sukzessive ein Signal, das durch den Schalter (212) empfangen wird, für die Abwärtsumsetzung auszuwählen.

11. Computerprogramm, das konfiguriert ist, einen Computerprozess auszuführen, wobei der Prozess Folgendes umfasst:
selektives Abtasten (400) sowohl eines Teils eines Hochfrequenzsignals, das von einer Hochfrequenzverstärkereinheit (204) zu einer Antenne (206) des Sender/Empfängers für ein Telekommunikationssystem läuft, als auch wenigstens eines Teils des Hochfrequenzsignals, das von der Antenne (206) reflektiert ist;
Abwärtsumsetzen (402) der abgetasteten Hochfrequenzsignale;
Messen (404) einer Stärke der abwärtsumgesetzten Signale; und
Steuern (406), als eine Funktion der gemessenen Stärke, wenigstens eines Parameters der Verstärkereinheit, die das Hochfrequenzsignal verstärkt.

12. Computerprogramm nach Anspruch 11, wobei der Prozess ferner Folgendes umfasst:
selektives Abtasten wenigstens eines Teils des durch die Antenne (206) empfangenen Hochfrequenzsignals.

13. Computerprogramm nach Anspruch 11, wobei der Prozess ferner Folgendes umfasst:
Steuern eines Parameters, der eine Verstärkung der Verstärkereinheit (204) ist.

14. Computerprogramm nach Anspruch 11, wobei der Prozess ferner Folgendes umfasst:
Steuern eines Parameters, der eine Leistung ist, die der Verstärkereinheit (204) zugeführt wird.

15. Computerprogramm nach Anspruch 11, wobei der Prozess ferner Folgendes umfasst:
Empfangen durch einen Schalter (212) des Signals, das in der Richtung von der Verstärkereinheit (204) zu der Antenne 206 läuft, und eines Teils eines Signals, das von der Antenne (206) reflektiert ist und das in der Richtung von der Antenne 206 zu der Verstärkereinheit (204) läuft;
sukzessives Auswählen durch den Schalter (212) eines Signals, das durch den Schalter (212) empfangen wird, für die Abwärtsumsetzung.

## Revendications

1. Procédé comprenant :
l'échantillonnage sélectif (400), avec un coupleur (208), à la fois d'au moins une partie d'un signal à radiofréquence se déplaçant depuis une unité amplificateur (204) vers une antenne (206) d'un émetteur-récepteur pour un système de télécommunication, et d'au moins une partie du signal à radiofréquence réfléchi depuis l'antenne (206) ;
l'abaissement de la fréquence (402) des signaux à radiofréquence échantillonnés ;
la mesure (404) des intensités des signaux à fréquence abaissée ; et
la commande (406), comme une fonction des intensités mesurées, d'au moins un paramètre de l'unité amplificateur (204) amplifiant le signal à radiofréquence.

2. Procédé selon la revendication 1, ce procédé comprenant en outre :
l'échantillonnage sélectif d'au moins une partie du signal à radiofréquence reçu par l'antenne (206).

3. Procédé selon la revendication 1, ce procédé comprenant en outre :
la commande d'un paramètre qui est une amplification de l'unité amplificateur (204).

4. Procédé selon la revendication 1, ce procédé comprenant en outre :
la commande d'un paramètre qui est une puissance alimentée à l'unité amplificateur (204).

5. Procédé selon la revendication 1, ce procédé comprenant en outre :
la réception, par un commutateur (212), du signal se déplaçant dans la direction depuis l'unité amplificateur (204) vers l'antenne (206) et d'une partie d'un signal réfléchi depuis l'antenne (206) se déplaçant dans la direction depuis l'antenne (206) vers l'unité amplificateur (204) ;
la sélection successive, par le commutateur (212), d'un signal reçu par le commutateur (212) pour l'abaissement de la fréquence.

6. Émetteur-récepteur pour un système de télécommunication, ledit émetteur-récepteur comprenant :
un moyen (208) pour échantillonner sélectivement à la fois au moins une partie d'un signal à radiofréquence se déplaçant d'une unité amplificateur radiofréquence (204) vers une antenne (206) de l'émetteur-récepteur et au moins une partie du signal à radiofréquence réfléchi depuis l'antenne (206) ;
un moyen (210) pour abaisser la fréquence des signaux à radiofréquence échantillonnés en se basant sur les signaux à radiofréquence échantillonnés ;
un moyen (214) pour mesurer une intensité des signaux à radiofréquence à fréquence abaissée en se basant sur les signaux à radiofréquence à fréquence abaissée ; et
un moyen (216) pour commander au moins un paramètre de l'unité amplificateur comme une fonction de l'intensité mesurée en se basant sur l'intensité mesurée des signaux à radiofréquence échantillonnés.

7. Émetteur-récepteur selon la revendication 6, cet émetteur-récepteur comprenant en outre un coupleur (208) configuré de façon à échantillonner sélectivement au moins une partie du signal à radiofréquence reçu par l'antenne (206).

8. Émetteur-récepteur selon la revendication 6, cet émetteur-récepteur comprenant en outre un dispositif de commande (216) configuré de façon à commander un paramètre qui est une amplification de l'unité amplificateur (204).

9. Émetteur-récepteur selon la revendication 6, cet émetteur-récepteur comprenant en outre :
un dispositif de commande (216) configuré de façon à commander un paramètre qui est une puissance alimentée à l'unité amplificateur (204).

10. Émetteur-récepteur selon la revendication 6, cet émetteur-récepteur comprenant en outre :
un commutateur (212) configuré de façon à recevoir le signal se déplaçant dans la direction depuis l'unité amplificateur (204) vers l'antenne (206) et une partie d'un signal réfléchi depuis l'antenne (206) se déplaçant dans la direction depuis l'antenne (206) vers l'unité amplificateur (204), ce commutateur (212) étant configuré de façon à sélectionner successivement un signal reçu par le commutateur (212) pour l'abaissement de la tension.

11. Programme d'ordinateur configuré de façon à exécuter un processus informatique, ce processus comprenant :
l'échantillonnage sélectif (400) à la fois d'au moins une partie d'un signal à radiofréquence se déplaçant d'une unité amplificateur radiofréquence (204) vers une antenne (206) d'un système de télécommunication à émetteur-récepteur et d'au moins une partie du signal à radiofréquence réfléchi depuis l'antenne (206) ;
l'abaissement de la fréquence (402) des signaux à radiofréquence échantillonnés ;
la mesure (404) d'une intensité des signaux à fréquence abaissée ; et
la commande (406), comme une fonction de l'intensité mesurée, d'au moins un paramètre de l'unité amplificateur amplifiant le signal à radiofréquence.

12. Programme d'ordinateur selon la revendication 11, le processus comprenant en outre :
l'échantillonnage sélectif d'au moins une partie du signal à radiofréquence reçu par l'antenne (206).

13. Programme d'ordinateur selon la revendication 11, le processus comprenant en outre :
la commande d'un paramètre qui est une amplification de l'unité amplificateur (204).

14. Programme d'ordinateur selon la revendication 11, le processus comprenant en outre :
la commande d'un paramètre qui est une puissance alimentée à l'unité amplificateur (204).

15. Programme d'ordinateur selon la revendication 11, le processus comprenant en outre :
la réception, par un commutateur (212), du signal se déplaçant dans la direction depuis l'unité amplificateur (204) vers l'antenne (206) et d'une partie d'un signal réfléchi depuis l'antenne (206) se déplaçant dans la direction depuis l'antenne (206) vers l'unité amplificateur (204) ;
la sélection successive, par le commutateur (212), d'un signal reçu par le commutateur (212) pour l'abaissement de la fréquence.
